(19) Europäisches Patentamt
European Patent Office
Office européen des brevets

(11) **EP 2 232 537 B1**

(12) **EUROPÄISCHE PATENTSCHRIFT**

(45) Veröffentlichungstag und Bekanntmachung des Hinweises auf die Patenterteilung:
**13.08.2014 Patentblatt 2014/33**

(21) Anmeldenummer: **08734312.5**

(22) Anmeldetag: **26.02.2008**

(51) Int Cl.:
*H01L 21/285* (2006.01)   *H01L 21/336* (2006.01)
*H01L 23/485* (2006.01)

(86) Internationale Anmeldenummer:
**PCT/DE2008/000331**

(87) Internationale Veröffentlichungsnummer:
**WO 2009/089806 (23.07.2009 Gazette 2009/30)**

(54) **ELEKTRISCHE KONTAKTIERUNG VON HALBLEITER-BAUELEMENTEN MIT GERINGEM KONTAKTWIDERSTAND**

ELECTRIC CONTACTING OF SEMICONDUCTOR COMPONENTS HAVING LOW CONTACT RESISTANCE

MISE EN CONTACT ELECTRIQUE DE COMPOSANTS A SEMI-CONDUCTEURS A FAIBLE RESISTANCE DE CONTACT

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **17.01.2008 DE 102008005016**

(43) Veröffentlichungstag der Anmeldung:
**29.09.2010 Patentblatt 2010/39**

(73) Patentinhaber: **Fraunhofer-Gesellschaft zur Förderung der angewandten Forschung e.V.
80686 München (DE)**

(72) Erfinder:
• **KAMPEN, Christian
91058 Erlangen (DE)**

• **BURENKOV, Alexander
91056 Erlangen (DE)**

(74) Vertreter: **Gagel, Roland
Patentanwalt Dr. Roland Gagel
Landsberger Strasse 480a
81241 München (DE)**

(56) Entgegenhaltungen:
JP-A- 7 183 486       JP-A- 2004 260 003
US-A- 4 072 545       US-A- 6 133 105
US-A1- 2003 006 462   US-A1- 2003 148 563
US-A1- 2004 129 981   US-A1- 2006 057 792
US-B1- 6 441 435      US-B1- 6 593 217

## Beschreibung

**Technisches Anwendungsgebiet**

Die vorliegende Erfindung betrifft ein Halbleiterbauelement, das wenigstens eine elektrische Kontaktfläche zur Herstellung eines elektrischen Kontaktes zwischen einem Halbleiterbereich und einem metallischen Material aufweist, sowie ein Verfahren zur Herstellung der elektrischen Kontaktfläche. Bei den elektrischen Kontaktflächen kann es sich beispielsweise um Drain- und Source-Anschlüsse von Transistoren, insbesondere von decanano-MOSFETs, handeln.

**Stand der Technik**

Durch das aggressive Skalieren von CMOS Bauelementen in den vergangenen Jahren sind parasitäre Widerstände an den Source- und Drain-Kontakten von Transistoren zu einem wachsenden Problem geworden. Zur Verringerung dieser parasitären Widerstände ist es bekannt, die elektrischen Kontaktflächen zu silizidieren, um dadurch die gesamte Oberfläche des zu kontaktierenden Halbleiterbereiches, bspw. des aktiven Source- und Drain-Gebietes, als Kontaktfläche nutzen zu können. Zum Stand der Technik wird hierzu beispielhaft auf J. Kedzierski et al., "Issues in NiSi-gated FDSOI device integration", in IEDM Tech. Dig. 2003 hingewiesen, die eine derartige Silizidierung der Source- und Drain-Kontaktflächen vornehmen.

Die Kontaktwiderstände einer silizidierten elektrischen Kontaktfläche zwischen einem Halbleiterbereich und einem metallischen Anschlusselement folgen der Gleichung:

$$ R_{CO} = \frac{\rho_c}{W \cdot l_c} $$

Dabei steht $\rho_c$ für den spezifischen Kontaktwiderstand zwischen der Metallfläche und dem Silizium darunter. W gibt die Weite des Kontaktes und $l_c$ die Kontaktlänge an, die im Falle eines Transistors der Ausdehnung der Kontaktfläche in Kanalrichtung des Transistors entspricht. Die Kontaktlänge $l_c$ ist zu einer kritischen Größe geworden, seitdem die Transistoren in den Nanometerbereich skaliert worden sind. Der spezifische Kontaktwiderstand $\rho_c$ ist zudem abhängig von der Oberflächen-Dotierkonzentration $N_d$ und der Schottky-Barriere $\Phi_B$ des verwendeten Metalls oder Silizides.

$$ \rho_c \propto \exp\left( \frac{4\pi\Phi_B}{qh} \sqrt{\frac{m^* \varepsilon_{Si}}{N_d}} \right) $$

Wobei q die Elementarladung eines Elektrons, m* die effektive Masse, $\varepsilon_{Si}$ die Dielektrizitätskonstante von Silizium und h die Plancksche Konstante angeben. Zur weiteren Minimierung der Kontaktwiderstände werden derzeit Experimente zu alternativen Oberflächendotierstoffen wie bspw. Schwefel durchgeführt, um dadurch den spezifischen Kontaktwiderstand der Metall-Silizium-Grenzfläche zu verringern.

Die Einführung neuer Materialien in einen CMOS-Prozess ist jedoch mit erheblichem Aufwand und Kosten verbunden, da der Prozess dadurch in der Regel komplizierter wird.

Aus US 2003/006462 A1 ist es bekannt, die Kontaktflächen der Drain- und Source-Halbleitergebiete dadurch zu vergrößern, dass vertikale Gräben in die Halbleiterbereiche geätzt werden. Die entstehenden Seitenflächen dienen als zusätzliche Kontaktflächen.

JP 2004 260003 A zeigt eine Verringerung des Kontaktwiderstands durch Strukturierung der Oberfläche der Halbleitergebiete in der Tiefe.

Die US 6 133 105 A zeigt eine Verringerung des Kontaktwiderstands durch die teilweise Silizierung einer seitlichen Begrenzungsfläche des Drain- bzw. Source-Halbleiterbereiches, die bei der Erzeugung eines Isolationsgrabens frei gelegt wird.

**Darstellung der Erfindung**

Die Aufgabe der vorliegenden Erfindung besteht darin, eine Ausgestaltung einer elektrischen Kontaktfläche in einem Halbleiterbauelement sowie ein Verfahren zur Herstellung der Kontaktfläche anzugeben, mit denen ein reduzierter parasitärer Widerstand bei kostengünstiger Herstellbarkeit erreicht wird.

Die Aufgabe wird mit den Halbleiterbauelementen gemäß den Patentansprüchen 1 und 3 sowie den Verfahren gemäß den Patentansprüchen 2 und 4 gelöst. Vorteilhafte Ausgestaltungen des Halbleiterbauelementes sowie des Verfahrens lassen sich der nachfolgenden Beschreibung sowie den Ausführungsbeispielen entnehmen.

Der Grundgedanke der vorliegenden Erfindung besteht darin, die elektrische Kontaktfläche zu vergrößern, ohne den für das Bauelement erforderlichen Flächenaufwand zu erhöhen. Gemäß einem Merkmal der vorliegenden Erfindung wird eine Vergrößerung der Kontaktfläche durch eine Strukturierung einer Halbleiterschicht des zu kontaktierenden Halbleiterbereichs oder eines darauf aufgebrachten Halbleitermaterials in der Tiefe erreicht, so dass sich eine dreidimensionale Oberflächentopographie ergibt. Durch diese Oberflächentopographie wird bei gleicher lateraler Ausdehnung der Kontaktfläche eine Vergrößerung der Oberfläche und somit eine Verringerung des Kontaktwiderstandes erreicht. Dabei erfolgt auch weiterhin eine Silizidierung dieser Oberfläche.

Diese Vergrößerung der Kontaktfläche kann hierbei durch Einbringen von Vertiefungen, wie bspw.

Gräben, oder durch Erzeugen von Erhöhungen realisiert werden und lässt sich vorteilhaft mit einem Standard CMOS-Prozess durchführen. In einer Verfahrensvariante wird hierbei auf den zu kontaktierenden Halbleiterbereich eine selektive epitaktische Schicht (SEG) aufgewachsen und zur Erzeugung der gewünschten elektrischen Leitfähigkeit dotiert. Das epitaktische Aufwachsen von SEG-Schichten ist bspw. bereits von der Herstellung von SOI-Bauteilen (SOI: Silicon on insulator) bekannt. Um die Kontaktfläche anschließend zu vergrößern, werden nach der Erzeugung und Dotierung der SEG-Schicht ein Lithographie-Schritt und Ätzschritt durchgeführt, um die gewünschte dreidimensionale Oberflächentopographie zu erhalten. Beispielsweise können hierzu geeignet Gräben in die SEG-Schicht geätzt werden. Nach der Erzeugung der Oberflächentopographie wird wie bisher ein silizidierungsfähiges Metall, bspw. Nickel oder Kobalt, auf der strukturierten Oberfläche abgeschieden, um anschließend durch einen Hochtemperaturschritt eine Silizidschicht für die elektrische Kontaktfläche zu erzeugen.

In einer anderen Ausgestaltung kann bei ausreichender Dicke des zu kontaktierenden Halbleiterbereichs auch direkt dieser Halbleiterbereich in der oben genannten Weise ohne vorheriges Aufbringen einer SEG-Schicht strukturiert und silizidiert werden.

Durch die vorstehend beschriebene Vergrößerung der elektrischen Kontaktfläche lassen sich bspw. die parasitären Kontaktwiderstände von Source- und Drain-Kontakten um mindestens den Faktor 2/3 reduzieren. Die Erfindung ist dabei vor allem für decanano-skalierte CMOS Bauelemente von Vorteil, deren Source- und Drain-Kontaktlängen in sub-100 nm Bereich liegen. Die Reduzierung der parasitären Kontaktwiderstände, die derzeit im Bereich zwischen 500 und 200 $\Omega\mu$m liegen, um den. Faktor 2/3 hat eine direkte Auswirkung auf den Gesamtwiderstand des Bauteils und somit auf den On-Strom. Damit wird eine höhere Schaltgeschwindigkeit des Bauteils erreicht, da der On-Strom des Bauteils direkt von den parasitären Kontaktwiderständen beeinflusst wird. Bei der obigen Reduzierung der parasitären Kontaktwiderstände steigt der On-Strom um den Faktor 1,5 an. Dies kommt einer Reduzierung der Schaltverzögerung um den Faktor 2/3 gleich, die sich aus der Multiplikation der Bauelementekapazitäten C mit der Betriebsspannung $V_{DD}$ und der Division durch den On-Strom $I_{on}$ errechnet ($t = CV_{DD}/Ion$) . Das CMOS-Bauelement schaltet demnach 1,5 mal schneller. Dieser Vorteil wird durch eine Vergrößerung der Kontaktfläche durch dreidimensionale Strukturierung erreicht, so dass kein zusätzlicher Flächenverbrauch des CMOS-Bauelements auftritt. Die Herstellung einer vergrößerten elektrischen Kontaktfläche lässt sich ohne Verwendung zusätzlicher Materialien in einen Standard CMOS-Prozess einbinden.

Das Hauptanwendungsgebiet der vorliegenden Erfindung liegt im Bereich der Mikroelektronik, insbesondere bei integrierten Schaltungen. Besonders vorteilhaft können derartige elektrische Kontaktflächen bei Transistoren eingesetzt werden, die Strukturen im sub-100 nm Bereich aufweisen. Die Erfindung lässt sich selbstverständlich auch bei anderen Halbleiterbasierten Bauelementen anwenden, die über eine Metall-Halbleiter Grenzschicht als Kontakt verfügen, wie bspw. Schottky-Dioden.

**Kurze Beschreibung der Zeichnungen**

Das vorgeschlagene Halbleiterbauelement sowie das zugehörige Verfahren werden nachfolgend anhand von Ausführungsbeispielen in Verbindung mit den Zeichnungen nochmals näher erläutert. Hierbei zeigen in schematischer Darstellung:

Fig. 1     ein Beispiel für ein nicht beanspruchtes MOSFET-Bauelement mit einer vergrößerten Kontaktflächen;

Fig. 2     ein Beispiel für eine nicht beanspruchte, vergrößerte Kontaktfläche;

Fig. 3     ein weiteres Beispiel für eine nicht beanspruchte, vergrößerte Kontaktfläche;

Fig. 4     ein SOI MOSFET-Bauelement mit erfindungsgemäß ausgestalteten Kontaktflächen;

Fig. 5     ein weiteres Beispiel für eine erfindungsgemäß ausgestaltete Kontaktfläche;

Fig. 6     ein nicht beanspruchtes MOSFET-Bauelement mit vergrößerten Kontaktflächen;

Fig. 7     ein weiteres Beispiel für eine nicht beanspruchte, vergrößerte Kontaktfläche;

Fig. 8     ein weiteres Beispiel für eine nicht beanspruchte, vergrößerte Kontaktfläche;

Fig. 9     ein Beispiel für ein SOI MOSFET-Bauelement mit erfindungsgemäß ausgestalteten Kontaktflächen;

Fig. 10    ein weiteres Beispiel für eine erfindungsgemäß ausgestaltete Kontaktfläche; und

Fig. 11    ein weiteres Beispiel für eine nicht beanspruchte, vergrößerte Kontaktfläche.

**Wege zur Ausführung der Erfindung**

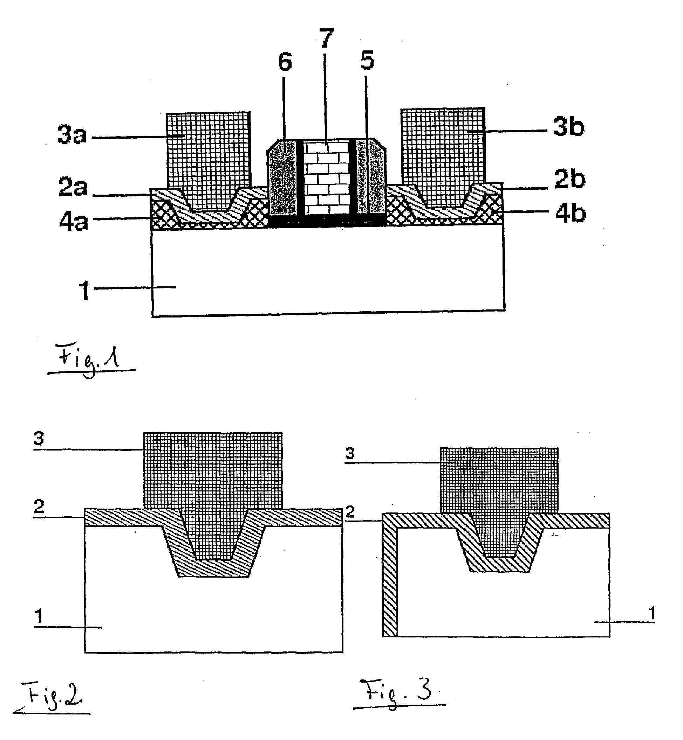

Figur 1 zeigt in schematischer Darstellung einen nicht beanspruchten MOSFET-Transistor, bei dem die Source- und Drain-Kontaktflächen vergrößert sind. In der Figur ist das Siliziumsubstrat 1 mit den nicht näher gekennzeichneten Source- und Drain-Halbleiterbereichen zu erkennen. Auf dieses Substrat wurde neben dem Gate- und Spaceroxid 5, den Nitrid-Spacern 6 und dem konventionellen Polysilizium-Gate 7 eine SEG-Schicht 4a, 4b aufgebracht. Die SEG-Schicht 4a, 4b wurde strukturiert, indem durch einen Lithographie- und einen Ätzschritt senkrecht zur Kanalrichtung des MOSFETs Gräben erzeugt wurden, wie dies aus Figur 1 ersichtlich ist. Die Erzeugung und Dotierung der SEG-Schichten 4a, 4b sowie des Polysilizium-Gates 7 mit dem Gate- und Spaceroxid 5 und den Nitrid-Spacern 6 kann in bekannter Weise erfolgen, wie dies aus dem Stand der Technik zur Herstellung von MOSFET-Bauelementen bekannt ist. Das Gleiche gilt für die anschließende Silizidierung der Oberfläche der strukturierten SEG-Schicht 4a, 4b durch Aufbringen eines geeigneten metallischen Materials und einen anschließenden Hochtemperaturschritt. Auf diese Weise werden die dargestellten Silizidschichten 2a, 2b erhalten, auf die anschließend die Metallkörper 3a, 3b aufgebracht werden, die das Bauelement mit den Leiterbahnen verbinden. Durch die dreidimensionale Strukturierung der SEG-Schicht 4a, 4b wird eine Vergrößerung der Oberfläche dieser Schicht und damit eine Vergrößerung der elektrischen Kontaktfläche erreicht, die zu einer Reduzierung des Kontaktwiderstandes führt.

Figur 2 zeigt hierzu nochmals das nicht beanspruchte Prinzip dieser Vergrößerung der Kontaktfläche durch Ausbildung eines Grabens, in diesem Beispiel in dem Siliziumsubstrat 1. Auch hier erfolgt anschließend eine Silizidierung der strukturierten Oberfläche zur Ausbildung der Silizidschicht 2. Durch Erzeugung eines Grabens geeigneter Tiefe kann die Kontaktfläche mindestens verdoppelt werden, so dass damit eine Halbierung des Kontaktwiderstandes erreicht wird.

Um die Kontaktfläche in nicht beanspruchter Weise weiter zu vergrößern, lassen sich zusätzlich die Seitenflächen des jeweiligen Gebietes silizidieren, indem die konventionell auf einem Wafer zwischen den Bauteilen verwendeten sog. Shallow Trench Isolations (STI) herausgeätzt, mit einem für die Silizidierung geeigneten Metall aufgefüllt und anschließend ebenfalls silizidiert werden. Der Überschuss des nicht silizidierten Metalls kann anschließend wieder entfernt werden, um die STI wieder mit Siliziumdioxid zu füllen und die Isolation zwischen den Bauelementen wieder herzustellen. Um Kurzschlüsse zwischen den auf einem Wafer nebeneinander angeordneten Bauelementen zu vermeiden, sollte das Oxid der STI nicht komplett entfernt werden, damit der Boden des Isolationsgrabens nicht silizidiert wird. In Figur 3 ist hierbei der zu kontaktierende Halbleiterbereich des Siliziumsubstrats 1 mit der in der Tiefe strukturierten und silizidierten Oberfläche sowie der silizidierten Seitenfläche zu erkennen, durch die eine zusammenhängende Silizidschicht 2 gebildet wird. Der zur Kontaktierung eingesetzte metallische Körper 3 ist in diesem wie auch in den nachfolgenden Figuren jeweils mit den Bezugszeichen 3, 3a oder 3b bezeichnet.

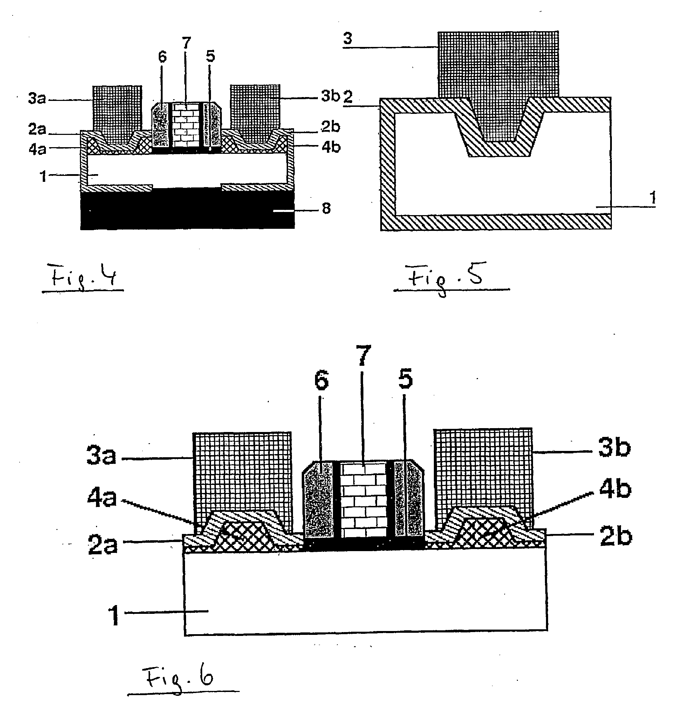

Für SOI MOSFETs gibt es zusätzlich die Möglichkeit, einen vergrabenen Kontakt hinzuzufügen, wie dies in den Figuren 4 und 5 dargestellt ist. Figur 4 zeigt hierzu zusätzlich das vergrabene Oxid 8 des SOI-Substrats, auf dem das Siliziumsubstrat 1 mit den zu kontaktierenden Halbleiterbereichen aufgebracht ist. Bei der in den Figuren 4 und 5 dargestellten erfindungsgemäßen Ausgestaltung werden vor der Erzeugung der SOI-Schichten die unteren Kontakte des Transistors in das Oxid 8 geätzt, mit Metall gefüllt und anschließend das Siliziumsubstrat 1 für die Transistoren darauf gebondet. Die weiteren Schritte können dann in gleicher Weise erfolgen, wie dies bereits anhand der Figuren 1 bis 3 erläutert wurde. Im Beispiel der Figuren 4 und 5 wurde in gleicher Weise wie in Figur 3 auch eine seitliche Silizidierung vorgenommen, so dass sich nach dem für die Silizidierung erforderlichen Hochtemperaturschritt, bei der auch das vergrabene Metall silizidiert wird, die in den Figuren 4 und 5 erkennbare zusammenhängende Silizidschicht 2 bzw. 2a und 2b ergibt.

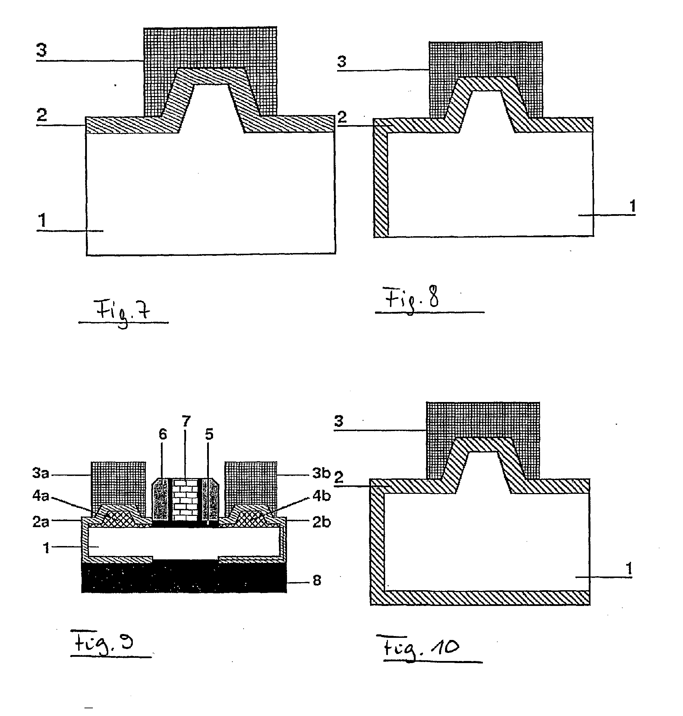

Alternativ zur Erzeugung eines Grabens in der SEG-Schicht 4a, 4b bzw. dem Siliziumsubstrat 1 lässt sich die Oberfläche der SEG-Schicht 4a, 4b oder des Siliziumsubstrats 1 auch zur Erzeugung von Erhebungen, bspw. in Form eines Kontakt-Pins durch einen Lithographie- und anschließenden Ätzschritt erzeugen. Dies ist anhand der folgenden Figuren 6 bis 10 veranschaulicht, wobei die Figuren 6 bis 8 nicht beanspruchte Ausgestaltungen und die Figuren 9 und 10 den Gegenstand der Erfindung zeigen.

Figur 6 zeigt hierbei ein nicht beanspruchtes MOSFET-Bauelement in schematischer Darstellung, bei dem die SEG-Schicht 4a, 4b zur Bildung einer derartigen Erhebung strukturiert ist. Die gleichen Bezugszeichen bezeichnen hierbei die gleichen Komponenten dieses Bauelements wie sie bereits in Zusammenhang mit der Figur 1 erläutert wurden. Auch hier erfolgt anschließend eine Silizidierung der strukturierten Oberfläche zur Bildung der Silizidschichten 2a und 2b. Durch die Erzeugung von Erhebungen lässt sich der gleiche Flächenzuwachs bewirken wie durch die Erzeugung der Gräben der Figuren 1 bis 5. Figur 7 zeigt das nicht beanspruchte Prinzip nochmals in schematischer Darstellung. Neben der Silizidierung der Oberseite des zu kontaktierenden Gebietes lässt sich auch hier, in gleicher Weise wie bei Figur 2, auch die Seite des jeweiligen Gebietes silizidieren, so dass die in Figur 8 erkennbare zusammenhängende Silizidschicht 2 gebildet wird. Durch diese seitliche Silizidierung wird die Kontaktfläche nochmals vergrößert.

Weiterhin lässt sich auch hier bei einem SOI MOSFET-Bauelement in einer erfindungsgemäßen Ausgestaltung ein vergrabener Kontakt zwischen dem Oxid 8 und dem Siliziumsubstrat 1 erzeugen, der die silizidierte Fläche und somit die Kontaktfläche des jeweiligen Halbleitergebietes weiter vergrößert. Dies ist in den Figuren 9 und 10 dargestellt und wurde bereits in Zusammenhang mit den Figuren 4 und 5 erläutert.

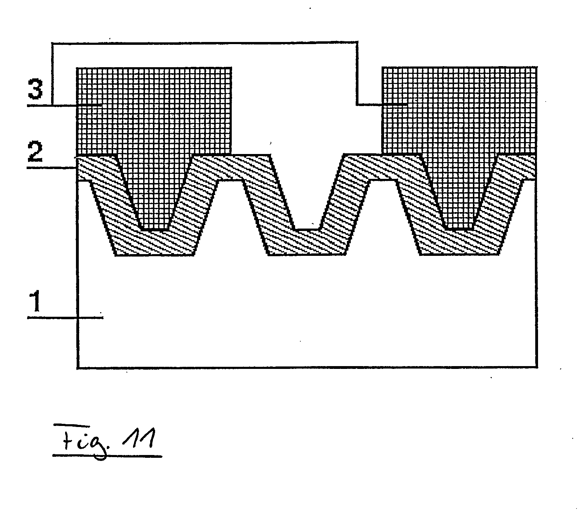

Eine nicht beanspruchte weitere Möglichkeit zur Vergrößerung der Kontaktierungsfläche stellt die sog. Kammstrukturierung der Kontakte dar, die bspw. auf die Weite des Bauelements angewendet werden kann, d. h. senkrecht zur Kanalrichtung bei einem Transistor. Dabei werden, wie in Figur 11 schematisch dargestellt, mehrere Gräben oder Pins in der Richtung senkrecht zur Kanalrichtung erzeugt, um die Kontaktfläche zu erhöhen. Hier besteht auch die Möglichkeit, mehrere parallel geschaltete metallische Kontaktkörper 3 auf diese Kontaktfläche aufzubringen. In Abhängigkeit von den Möglichkeiten der Lithographie- und Ätztechniken lassen sich derartige Kammstrukturen selbstverständlich auch in Richtung parallel zur Kanalrichtung erzeugen.

Bezugszeichenliste

1       Siliziumsubstrat
2       Silizidschicht
2a      Silizidschicht an Drain-Kontakt
2b      Silizidschicht an Source-Kontakt
3a      Metallkörper an Drain-Kontakt
3b      Metallkörper an Source-Kontakt
4a      SEG-Schicht an Drain-Kontakt
4b      SEG-Schicht an Source-Kontakt
5       Gate- und Spacer-Oxid
6       Nitrid-Spacer
7       Polysilizium-Gate
8       Oxidschicht

**Patentansprüche**

1.  Halbleiterbauelement,

    - das zumindest einen Transistor bildet, mit einem Drain- und einem Source-Halbleiterbereich auf einer Oxidschicht in einem SOI-Substrat, wobei untere Begrenzungsflächen der Drain- und Source-Halbleiterbereiche jeweils an die Oxidschicht angrenzen,
    - das wenigstens zwei elektrische Kontaktflächen zur Herstellung eines elektrischen Kontaktes zwischen dem Drain-Halbleiterbereich und einem metallischen Material und zwischen dem Source-Halbleiterbereich und einem metallischen Material aufweist, wobei
    - die Kontaktflächen jeweils durch eine Oberfläche einer in der Tiefe strukturierten Halbleiterschicht gebildet sind, wobei die Halbleiterschicht eine auf dem zu kontaktierenden Drain- oder Source-Halbleiterbereich (1) aufgebrachte und dotierte SEG-Schicht (4a, 4b) ist,
    - das seitliche Begrenzungsflächen der Drain- und Source-Halbleiterbereiche aufweist, die Oberseiten der Drain- und Source-Halbleiterbereiche (1), auf der jeweils die SEG-Schichten aufgebracht sind, jeweils mit den unteren Begrenzungsflächen der Drain- und Source-Halbleiterbereiche verbinden, dadurch charakterisiert, dass

    - die Oberfläche der in der Tiefe strukturierten Halbleiterschicht, die seitlichen Begrenzungsflächen der Drain- und Source-Halbleiterbereiche und die unteren Begrenzungsflächen der Drain- und Source-Halbleiterbereiche jeweils zusammenhängend silizidiert sind.

2.  Verfahren zur Herstellung der elektrischen Kontaktflächen eines Halbleiterbauelementes nach Anspruch 1,
    bei dem der Drain- und Source-Halbleiterbereich (1) in SOI-Technik auf einer Oxidschicht (8) erzeugt wird, wobei

    - vor dem Aufbringen einer den Drain- und Source-Halbleiterbereich (1) umfassenden Schicht jeweils eine Metallschicht unterhalb des Drain- und Source-Halbleiterbereichs in das Oxid (8) eingebettet wird,
    - bei dem auf den zu kontaktierenden Drain- oder Source-Halbleiterbereich (1) des Substrats epitaktisch jeweils eine Halbleiterschicht (4a, 4b) aufgewachsen und zur Erhöhung der elektrischen Leitfähigkeit dotiert wird,

    eine Oberfläche der Halbleiterschichten (4a, 4b) durch Strukturierung der Halbleiterschichten (4a, 4b) in der Tiefe vergrößert und die vergrößerten Oberflächen anschließend silizidiert werden, und dadurch charakterisiert, dass

    - mindestens eine seitliche Begrenzung des Drain-Halbleiterbereichs (1) zusammen mit der vergrößerten Oberfläche der auf dem Drain-Halbleiterbereich aufgewachsenen Halbleiterschicht (4a, 4b) und der Metallschicht unterhalb des Drain-Halbleiterbereichs (1) silizidiert werden, um eine zusammenhängende Silizidschicht (2) zu bilden und
    - mindestens eine seitliche Begrenzung des Source-Halbleiterbereichs (1) zusammen mit der vergrößerten Oberfläche der auf dem Source-Halbleiterbereich aufgewachsenen Halbleiterschicht (4a, 4b) und der Metallschicht unterhalb des Source-Halbleiterbereichs (1) silizidiert werden, um eine zusammenhängende Silizidschicht (2) zu bilden.

3.  Halbleiterbauelement,

    - das zumindest einen Transistor bildet, mit einem Drain- und einem Source-Halbleiterbereich auf einer Oxidschicht in einem SOI-Substrat, wobei untere Begrenzungsflächen der Drain- und Source-Halbleiterbereiche jeweils an die Oxidschicht angrenzen, wobei die Oberflächen der Drain- und Source-Halbleiterbereiche in der Tiefe strukturiert sind und jeweils eine in der Tiefe strukturierte Halbleiterschicht bilden,
- das wenigstens zwei elektrische Kontaktflächen zur Herstellung eines elektrischen Kontaktes zwischen dem Drain-Halbleiterbereich und einem metallischen Material und zwischen dem Source-Halbleiterbereich und einem metallischen Material aufweist, wobei
- die Kontaktflächen jeweils durch eine Oberfläche der in der Tiefe strukturierten Halbleiterschichten gebildet sind,
- das seitliche Begrenzungsflächen der Drain- und Source-Halbleiterbereiche aufweist, die Oberseiten der Drain- und Source-Halbleiterbereiche (1) jeweils mit den unteren Begrenzungsflächen der Drain- und Source-Halbleiterbereiche verbinden, dadurch charakterisiert, dass
- die Oberfläche der in der Tiefe strukturierten Halbleiterschichten, die seitlichen Begrenzungsflächen der Drain- und Source-Halbleiterbereiche und die unteren Begrenzungsflächen jeweils zusammenhängend silizidiert sind.

4. Verfahren zur Herstellung der elektrischen Kontaktflächen eines Halbleiterbauelementes nach Anspruch 3,

- bei dem der Drain- und Source-Halbleiterbereich (1) in SOI-Technik auf einer Oxidschicht (8) erzeugt wird, wobei
- vor dem Aufbringen einer den Drain- und Source-Halbleiterbereich (1) umfassenden Schicht jeweils eine Metallschicht unterhalb des Drain- und Source-Halbleiterbereichs in das Oxid (8) eingebettet wird,
- bei dem jeweils eine Oberfläche der zu kontaktierenden Drain- und Source-Halbleiterbereiche (1) des Substrats durch Strukturierung der Drain- und Source-Halbleiterbereiche in der Tiefe vergrößert und die vergrößerten Oberflächen anschließend silizidiert werden, wodurch jeweils in der Tiefe strukturierte Halbleiterschichten mit silizidierter Oberfläche gebildet werden, dadurch charakterisiert, dass
- bei dem mindestens eine seitliche Begrenzung des Drain-Halbleiterbereichs (1) zusammen mit der vergrößerten Oberfläche des zu kontaktierenden Drain-Halbleiterbereichs und der Metallschicht unterhalb des Drain-Halbleiterbereichs (1) silizidiert werden, um eine zusammenhängende Silizidschicht (2) zu bilden, und
- bei dem mindestens eine seitliche Begrenzung des Source-Halbleiterbereichs (1) zusammen mit der vergrößerten Oberfläche des zu kontaktierenden Source-Halbleiterbereichs (1) und der Metallschicht unterhalb des Source-Halbleiterbereichs (1) silizidiert werden, um eine zusammenhängende Silizidschicht (2) zu bilden.

**Claims**

1. A semiconductor component,

- forming at least a transistor, with a drain and a source semiconductor area on an oxide layer in a SOI substrate, wherein lower boundary surfaces of the drain and source semiconductor areas are each adjacent to the oxide layer,
- comprising at least two electrical contact surfaces for creating an electrical contact between the drain semiconductor area and a metallic material, and between the source semiconductor area and a metallic material, wherein
- each of the contact surfaces is formed by a surface of a semiconductor layer that is structured in depth, wherein the semiconductor layer is a doped SEG layer (4a, 4b) applied on the drain or source semiconductor area (1) that is to be contacted,
- comprising lateral boundary surfaces of the drain and source semiconductor areas, that connect upper sides of the drain and source semiconductor areas (1), on each of which the SEG layers are applied, with each of the lower boundary surfaces of the drain and source semiconductor areas,
**characterised in that**
- the surface of the semiconductor layer that is structured in depth, the lateral boundary surfaces of the drain and source semiconductor areas and the lower boundary surfaces of the drain and source semiconductor areas are each contiguously silicided.

2. A method for producing the electrical contact surfaces of a semiconductor component according to claim 1,
in which the drain and source semiconductor area (1) is created on an oxide layer (8) using SOI technology, wherein

- a metallic layer is embedded in the oxide (8) below each drain and source semiconductor area before a layer comprising the drain and source semiconductor area (1) is applied,
- in which a semiconductor layer (4a, 4b) is grown epitaxially on each of the drain or source semiconductor areas (1) that is to be contacted and is doped to increase the electrical conductivity thereof,

a surface of the semiconductor layers (4a, 4b) is enlarged by structuring the semiconductor layers (4a, 4b) in depth and the enlarged surfaces are then silicided, and **characterised in that**

- at least one lateral boundary of the drain semiconductor area (1) is silicided together with the enlarged surface of the semiconductor layer (4a, 4b) grown on the drain semiconductor area and the metal layer below the drain semiconductor area (1) to form a contiguous silicide layer (2), and

- at least one lateral boundary of the source semiconductor area (1) is silicided together with the enlarged surface of the semiconductor layer (4a, 4b) grown on the source semiconductor area and the metal layer below the source semiconductor area (1) to form a contiguous silicide layer (2).

3. A semiconductor component,

- forming at least a transistor, with a drain and a source semiconductor area on an oxide layer in a SOI substrate, wherein lower boundary surfaces of the drain and source semiconductor areas are each adjacent to the oxide layer, wherein the surfaces of the drain and source semiconductor areas are structured in depth, and each forms a semiconductor layer that is structured in depth,

- comprising at least two electrical contact surfaces for creating an electrical contact between the drain semiconductor area and a metallic material, and between the source semiconductor area and a metallic material, wherein

- each of the contact surfaces is formed by a surface of the semiconductor layers that are structured in depth,

- comprising the lateral boundary surfaces of the drain and the source semiconductor areas (1) that connect upper sides of the drain and source semiconductor areas (1) with each of the lower boundary surfaces of the drain and source semiconductor areas,

**characterised in that**

- the surface of the semiconductor layers that are structured in depth, the lateral boundary surfaces of the drain and source semiconductor areas and the lower boundary surfaces are each contiguously silicided.

4. The method for producing the electrical contact surfaces of a semiconductor component according to claim 3,

- in which the drain and source semiconductor area (1) is created on an oxide layer (8) using SOI technology, wherein

- a metallic layer is embedded in the oxide (8) below each drain and source semiconductor area before a layer comprising the drain and source semiconductor area (1) is applied,

- in which a surface of each of the drain and source semiconductor areas (1) to be contacted in the substrate are enlarged by structuring the drain and the source semiconductor areas in depth, and the enlarged surfaces are then silicided, so that semiconductor layers, each structured in depth and having a silicided surface are formed,

**characterised in that**

- at least a lateral boundary of the drain semiconductor area (1) is silicided together with the enlarged surface of the drain semiconductor area to be contacted and the metal layer below the drain semiconductor area (1) to form a contiguous silicide layer (2), and

- at least a lateral boundary of the source semiconductor area (1) is silicided together with the enlarged surface of the source semiconductor area (1) to be contacted and the metal layer below the source semiconductor area (1) to form a contiguous silicide layer (2).

**Revendications**

1. Composant à semi-conducteur,

- lequel forme au moins un transistor, avec une zone semi-conductrice de drain et une zone semi-conductrice de source sur une couche d'oxyde dans un substrat SOI, des surfaces de délimitation inférieures des zones semi-conductrices de drain et de source jouxtant respectivement la couche d'oxyde,

- lequel présente au moins deux surfaces de contact électrique pour établir un contact électrique entre la zone semi-conductrice de drain et un matériau métallique et entre la zone semi-conductrice de source et un matériau métallique,

- les surfaces de contact étant respectivement formées par une surface d'une couche semi-conductrice structurée en profondeur, la couche semi-conductrice étant une couche SEG (4a, 4b) dopée et appliquée sur la zone semi-conductrice de drain ou de source (1) à contacter,

- lequel présente des surfaces de délimitation latérales des zones semi-conductrices de drain et de source, lesquelles relient des faces supérieures des zones semi-conductrices de drain et de source (1), sur lesquelles les couches SEG sont respectivement appliquées, respectivement aux surfaces de délimitation inférieures des zones semi-conductrices de drain et de source,

**caractérisé en ce que**

- la surface de la couche semi-conductrice structurée en profondeur, les surfaces de délimitation latérales des zones semi-conductrices de drain et de source et les surfaces de délimitation inférieures des zones semi-conductrices de drain et de source sont respectivement recouvertes de siliciure de façon continue.

**2.** Procédé pour fabriquer les surfaces de contact électrique d'un composant à semi-conducteur selon la revendication 1,
dans lequel la zone semi-conductrice de drain et celle de source (1) est produite selon la technique SOI sur une couche d'oxyde (8), moyennant quoi

- avant l'application d'une couche comprenant la zone semi-conductrice de drain et celle de source (1), respectivement une couche métallique est noyée dans l'oxyde au-dessous de la zone semi-conductrice de drain et celle de source,
- dans lequel on fait respectivement croître de manière épitaxiale une couche semi-conductrice (4a, 4b) sur la zone semi-conductrice de drain ou de source (1) à contacter du substrat en la dopant pour augmenter la capacité de conduction électrique,

une surface des couches semi-conductrices (4a, 4b) étant agrandie grâce à une structuration en profondeur des couches semi-conductrices (4a, 4b) et les surfaces agrandies étant ensuite recouvertes de siliciure, et **caractérisé en ce que**

- au moins une délimitation latérale de la zone semi-conductrice de drain (1) est recouverte de siliciure ensemble avec la surface agrandie de la couche semi-conductrice (4a, 4b) que l'on a fait croître sur la zone semi-conductrice de drain et la couche métallique au-dessous de la zone semi-conductrice de drain (1) afin de former une couche de siliciure continue (2) et
- au moins une délimitation latérale de la zone semi-conductrice de source (1) étant recouverte de siliciure ensemble avec la surface agrandie de la couche semi-conductrice (4a, 4b) que l'on a fait croître sur la zone semi-conductrice de source et la couche métallique au-dessous de la zone semi-conductrice de source (1) afin de former une couche de siliciure continue (2).

**3.** Composant à semi-conducteur,

- lequel forme au moins un transistor, avec une zone semi-conductrice de drain et une zone semi-conductrice de source sur une couche d'oxyde dans un substrat SOI, des surfaces de délimitation inférieures des zones semi-conductrice de drain et de source jouxtant respectivement la couche d'oxyde, les surfaces des zones semi-conductrices de drain et de source étant structurées en profondeur et formant respectivement une couche semi-conductrice structurée en profondeur,
- lequel présente au moins deux surfaces de contact électrique pour établir un contact électrique entre la zone semi-conductrice de drain et un matériau métallique et entre la zone semi-conductrice de source et un matériau métallique,
- les surfaces de contact étant respectivement formées par une surface des couches semi-conductrices structurées en profondeur,
- lequel présente des surfaces de délimitation latérales des zones semi-conductrices de drain et de source, lesquelles relient respectivement des faces supérieures des zones semi-conductrices de drain et de source (1) aux surfaces de délimitation inférieures des zones semi-conductrices de drain et de source,
**caractérisé en ce que**
- la surface des couches semi-conductrices structurées en profondeur, les surfaces de délimitation latérales des zones semi-conductrices de drain et de source et les surfaces de délimitation inférieures sont respectivement recouvertes de siliciure de façon continue.

**4.** Procédé pour fabriquer les surfaces de contact électriques d'un composant à semi-conducteur selon la revendication 3,

- dans lequel la zone semi-conductrice de drain et celle de source (1) est produite selon la technique SOI sur une couche d'oxyde (8), moyennant quoi
- avant l'application d'une couche comprenant la zone semi-conductrice de drain et celle de source (1), respectivement une couche métallique est noyée dans l'oxyde (8) au-dessous de la zone semi-conductrice de drain et celle de source,
- dans lequel respectivement une surface des zones semi-conductrices de drain et de source (1) à contacter du substrat est agrandie par structuration en profondeur des zones semi-conductrices de drain et de source, et les surfaces agrandies étant ensuite recouvertes de siliciure de sorte à former respectivement des couches semi-conductrices structurées en profondeur avec une surface recouverte de siliciure,
**caractérisé en ce que**
- au moins une délimitation latérale de la zone semi-conductrice de drain (1) est recouverte de siliciure ensemble avec la surface agrandie de la zone semi-conductrice de drain à contacter et la couche métallique au-dessous de la zone semi-conductrice de drain (1) afin de former une couche de siliciure (2) continue, et

- **en ce que** au moins une délimitation latérale de la zone semi-conductrice de source (1) est recouverte de siliciure ensemble avec la surface agrandie de la zone semi-conductrice de source (1) à contacter et la couche métallique au-dessous de la zone semi-conductrice de source (1) afin de former une couche de siliciure (2) continue.

**3a** — **6** **7** **5** — **3b**

**2a** — — **2b**
**4a** — — **4b**

**1**

Fig.1

**3** — **2** — **1**

Fig.2

**3** — **2** — **1**

Fig.3

Fig. 4

Fig. 5

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2003006462 A1
- JP 2004260003 A
- US 6133105 A

**In der Beschreibung aufgeführte Nicht-Patentliteratur**

- **J. KEDZIERSKI et al.** Issues in NiSi-gated FDSOI device integration. *IEDM Tech. Dig.,* 2003